# EUROPEAN PATENT APPLICATION

(11) **EP 4 520 582 A1**
(43) Date of publication of application: **12.03.2025**
(21) Application number: 23863481.0
(22) Date of filing: 05.09.2023
(51) Int. Cl.: B60L 53/80, B60L 53/53, G06Q 10/083

(54) **APPARATUS AND METHOD FOR MANAGING BATTERY**

(30) Priority: 05.09.2022 KR 20220111914
(71) Applicant: LG Energy Solution, Ltd., Seoul 07335 (KR)
(72) Inventor: KIM, Ji-Eun, Daejeon 34122 (KR); LEE, Keun-Wook, Daejeon 34122 (KR); LEE, Sung-Gun, Daejeon 34122 (KR); CHOI, Jin-Hwee, Daejeon 34122 (KR)
(74) Representative: Plasseraud IP
(86) International application number: PCT/KR2023/013282
(87) International publication number: WO 2024/054014

(57) **Abstract**

A battery management apparatus according to an embodiment of the present disclosure includes a communication unit configured to receive battery information for a plurality of batteries; a priority setting unit configured to determine an index value of a performance index preset for the plurality of batteries based on the battery information and set a priority for the plurality of batteries based on the determined index value; and a battery determining unit configured to determine a target battery among the plurality of batteries based on the battery information and the priority and provide information about the determined target battery.

## Description

### TECHNICAL FIELD

The present application claims priority to Korean Patent Application No. 10-2022-0111914 filed on September 5, 2022 in the Republic of Korea, the disclosures of which are incorporated herein by reference.

The present disclosure relates to a battery management apparatus and method, and more particularly, to a battery management apparatus and method capable of managing a battery used in a battery swapping station (BSS).

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As power driving devices such as electric vehicles, electric motorcycles, and electric bicycles are commercialized, the demand for high-capacity and high-performance batteries is increasing. However, as the capacity of the battery increases, the disadvantage that the time required to charge the battery also increases is highlighted. To solve this problem, technology for rapidly charging batteries is being developed, but there are concerns that rapid charging may accelerate battery deterioration.

To solve this problem, a battery swapping station (BSS) has recently been introduced. By replacing the battery used in an electric vehicle or the like, with a candidate battery provided at the battery swapping station, the user has an advantage of quickly using a battery that has been charged to a certain level or above (e.g., a fully charged battery).

Meanwhile, the area where the BSS is installed may be classified into a hot zone where the number of battery replacements is relatively high, and a cold zone where the number of battery replacements is relatively small, depending on accessibility. Because batteries of a BSS installed in a hot zone are relatively actively replaced by the user, the batteries of the BSS installed in a hot zone may deteriorate due to active use. In other words, since the batteries in the hot zone deteriorate with use, there is a problem that deterioration may accelerate.

Meanwhile, the batteries of a BSS installed in a cold zone are not actively used, but may deteriorate during the standby process after being fully charged. In other words, the batteries in the cold zone deteriorate as they wait for use, which may result in reduced battery utilization efficiency.

Therefore, there is a need to develop technology that may promote overall battery usage efficiency and balanced degradation.

### DISCLOSURE

### Technical Problem

The present disclosure is designed to solve the problems of the related art, and therefore the present disclosure is directed to providing a battery management apparatus and method capable of managing usage efficiency and deterioration of batteries used in a battery swapping station.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a communication unit configured to receive battery information for a plurality of batteries; a priority setting unit configured to determine an index value of a performance index preset for the plurality of batteries based on the battery information and set a priority for the plurality of batteries based on the determined index value; and a battery determining unit configured to determine a target battery among the plurality of batteries based on the battery information and the priority and provide information about the determined target battery.

The battery determining unit may be configured to check SOC of each of the plurality of batteries based on the battery information and determine a battery having the highest priority and having SOC greater than or equal to a preset criterion SOC among the plurality of batteries as the target battery.

The communication unit may be configured to receive a battery replacement request and information of a criterion location from a user terminal.

The battery determining unit may be configured to select at least one candidate battery among the plurality of batteries based on a distance between the criterion location and the plurality of batteries and determine the target battery based on the SOC and the priority of the selected candidate battery.

The communication unit may be configured to receive information of a location of the user terminal or a location specified by a user as the information of the criterion location.

The communication unit may be configured to receive a battery replacement request from a battery swapping station.

The battery determining unit may be configured to select at least one candidate battery provided in the battery swapping station among the plurality of batteries and determine the target battery based on the SOC and the priority of the selected candidate battery.

The performance index may be configured to include at least one of deterioration, relative deterioration, relative usage amount, and stress score of each of the plurality of batteries.

The priority setting unit may be configured to determine the deterioration of each of the plurality of batteries based on the battery information and calculate the relative deterioration of each of the plurality of batteries by comparing the calculated deterioration with a criterion deterioration preset for each of the plurality of batteries.

The priority setting unit may be configured to calculate a usage amount of each of the plurality of batteries based on the battery information and calculate the relative usage amount of each of the plurality of batteries by comparing the calculated usage amount with a criterion usage amount preset for each of the plurality of batteries.

The priority setting unit may be configured to check a usage pattern of each of the plurality of batteries based on the battery information and calculate the stress score of each of the plurality of batteries by comparing the usage pattern of each of the plurality of batteries with a preset main pattern.

When the preset performance index is plural, the priority setting unit may be configured to determine a plurality of index values for each of the plurality of batteries and set a priority for the plurality of batteries by comparing the index values from a performance index with a preset high importance.

When the preset performance index is plural, the priority setting unit may be configured to determine a plurality of index values for each of the plurality of batteries, calculate a state score for each battery based on the plurality of determined index values, and set a priority for the plurality of batteries according to the calculated state score.

The priority setting unit may be configured to calculate the state score by weighting and adding a weight preset for each of the plurality of performance indexes to the corresponding index value.

A server according to another aspect of the present disclosure may comprise the battery management apparatus according to an aspect of the present disclosure.

A battery management method according to still another aspect of the present disclosure may comprise: a battery information receiving step of receiving battery information for a plurality of batteries; an index value determining step of determining an index value of a performance index preset for the plurality of batteries based on the battery information; a priority setting step of setting a priority for the plurality of batteries based on the determined index value; a target battery determining step of determining a target battery among the plurality of batteries based on the battery information and the priority; and a battery information providing step of providing information about the determined target battery.

### Advantageous Effects

According to one aspect of the present disclosure, since the battery management apparatus sets priority by complexly considering the index value of a plurality of batteries, it is possible to prevent uneven deterioration of the plurality of batteries.

Additionally, the battery management apparatus has an advantage of improving the user experience because it recommends an optimal battery to the user among a plurality of batteries by complexly considering battery information and priority.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a diagram schematically showing a performance index and a priority of a plurality of batteries according to an embodiment of the present disclosure.
FIG. 3 is a diagram schematically showing SOC of the plurality of batteries according to an embodiment of the present disclosure.
FIG. 4 is a diagram schematically showing the plurality of batteries and a criterion location according to an embodiment of the present disclosure.
FIG. 5 is a diagram schematically showing a battery swapping station according to an embodiment of the present disclosure.
FIG. 6 is a diagram schematically showing a server according to another embodiment of the present disclosure.
FIG. 7 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

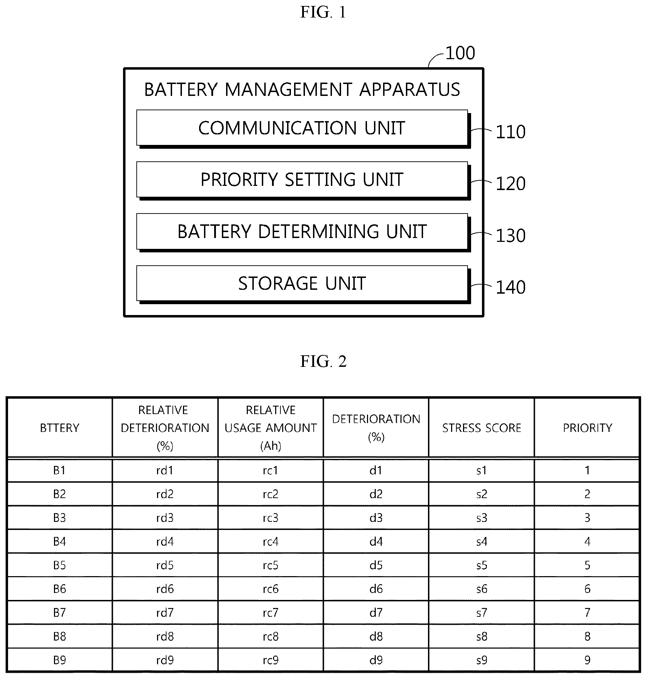

FIG. 1 is a diagram schematically showing a battery management apparatus 100 according to an embodiment of the present disclosure.

Referring to FIG. 1, the battery management apparatus 100 may include a communication unit 110, a priority setting unit 120, and a battery determining unit 130.

The communication unit 110 may be configured to receive battery information for a plurality of batteries.

Here, the battery means one physically separable independent cell including a negative electrode terminal and a positive electrode terminal. For example, one lithiumion battery or lithium polymer battery may be regarded as a battery. Additionally, the battery may mean a battery bank, a battery module or a battery pack in which a plurality of cells are connected in series and/or parallel.

Specifically, the communication unit 110 may be connected to enable communication with at least one battery swapping station. Additionally, the communication unit 110 may receive battery information about the battery provided in the battery swapping station from the battery swapping station. For example, the communication unit 110 may receive state information for at least one of voltage, current, capacity, resistance, temperature, SOC (state of charge), and SOH (state of health) for the plurality of batteries and usage information about usage pattern as the battery information.

The priority setting unit 120 may be configured to determine an index value for a performance index preset for the plurality of batteries, based on the battery information.

Specifically, the priority setting unit 120 may determine the index value for the performance index for each of the plurality of batteries using the battery information received by the communication unit 110.

For example, the performance index may be configured to include at least one of deterioration, relative deterioration, relative usage amount, and stress score for each of the plurality of batteries. Here, the deterioration is an index of the SOH of the battery, and the relative deterioration is an index of the deterioration of the battery compared to a preset criterion deterioration. The relative usage amount is an index of the usage amount of the battery compared to a preset criterion usage amount. The stress score is an index that scores the usage pattern of the battery. Specific descriptions of relative deterioration, relative usage amount, and stress score will be provided later.

FIG. 2 is a diagram schematically showing a performance index and a priority of a plurality of batteries according to an embodiment of the present disclosure.

Referring to FIG. 2, the plurality of batteries may include first to ninth batteries B1 to B9. Additionally, the priority setting unit 120 may determine the index value for the performance index (relative deterioration, relative usage amount, deterioration, and stress score) of the first to ninth batteries B1 to B9. For example, the relative deterioration of the first battery B1 is rd1 (%), the relative usage amount is rc1 (Ah), the deterioration is d1 (%), and the stress score is s1.

The priority setting unit 120 may be configured to set the priority for the plurality of batteries based on the determined index value.

Specifically, the priority setting unit 120 may set the priority between the plurality of batteries based on the index value determined for each of the plurality of batteries. For example, a battery with high priority is likely to be selected as a target battery that is a replacement target. Accordingly, the priority setting unit 120 may determine the priorities for the plurality of batteries so as not to overlap.

For example, when there is one preset performance index, the priority setting unit 120 may determine the priority for the plurality of batteries by comparing the sizes of the index values of the plurality of batteries.

As another example, when the preset performance index is plural, the priority setting unit 120 may determine the priority for the plurality of batteries by comprehensively considering the plurality of index values of the plurality of batteries.

In the embodiment of FIG. 2, there are a total of four performance indexes: relative deterioration, relative usage amount, deterioration, and stress score. The priority setting unit 120 may set the priority of the first to ninth batteries B1 to B9 by comprehensively considering the index values of the four performance indexes. For example, the priorities of the first to ninth batteries B1 to B9 are 1 to 9 in order. Here, note that the smaller the value of priority, the higher the priority. That is, in the embodiment of FIG. 2, the priority determined considering the plurality of index values is highest for the first battery B1 and lowest for the ninth battery B9.

The battery determining unit 130 may be configured to determine a target battery among the plurality of batteries based on the battery information and the priority.

Specifically, the battery determining unit 130 may determine the target battery by considering both the battery information and the priority rather than relying only on the priority set by the priority setting unit 120. Here, the target battery is a battery selected according to the battery information and the priority, and refers to a battery most recommended as a replacement target among the plurality of batteries.

For example, the battery determining unit 130 may determine the target battery based on the priority and at least one of the state information that can be obtained from the battery information. As another example, the battery determining unit 130 may determine the target battery based on the priority and the usage information that can be obtained from the battery information. As another example, the battery determining unit 130 may determine the target battery based on at least one of the state information, the usage information, and the priority.

Below, an embodiment in which the battery determining unit 130 determines the target battery based on the SOC and the priority of the battery will be described. However, note that the factors considered by the battery determining unit 130 in determining the target battery are not limited by the following examples.

The battery determining unit 130 may be configured to check the SOC of each of the plurality of batteries based on the battery information.

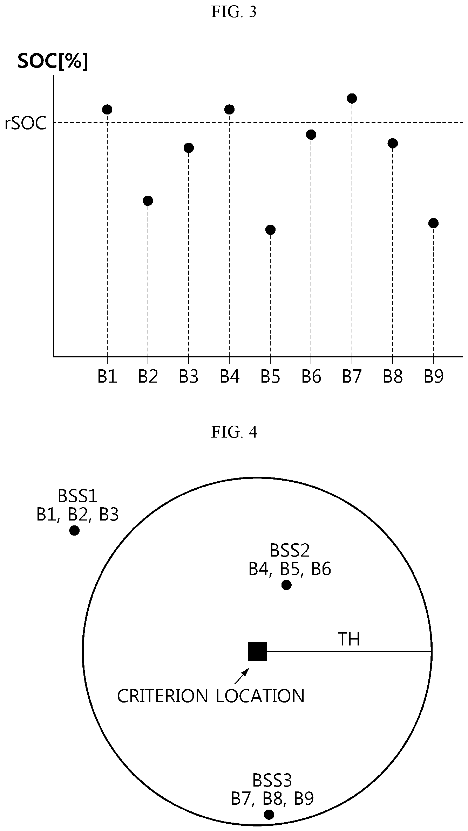

FIG. 3 is a diagram schematically showing SOC of the plurality of batteries according to an embodiment of the present disclosure.

The battery determining unit 130 may be configured to determine a battery having the highest priority and an SOC greater than or equal to a preset criterion SOC, among the plurality of batteries, as the target battery.

As explained earlier, the target battery is a battery most recommended as a replacement target battery. Therefore, the battery determining unit 130 may determine the target battery among the plurality of batteries by considering the SOC and the priority of the plurality of batteries.

In the embodiment of FIG. 3, the SOCs of the first battery B 1, the fourth battery B4, and the seventh battery B7 are greater than or equal to the criterion SOC. Therefore, the battery determining unit 130 may determine the target battery according to the priority among the first battery B 1, the fourth battery B4, and the seventh battery B7.

Preferably, the first to ninth batteries B1 to B9 are each provided in the battery swapping station, so that the communication unit 110 may obtain the battery information. Also, because the battery provided in the battery swapping station is a candidate battery that can be replaced, it can be charged while it is provided in the battery swapping station. That is, in the embodiment of FIG. 3, the SOCs of the first battery B1, the fourth battery B4, and the seventh battery B7 are greater than the criterion SOC, but after the plurality of batteries are further charged, the SOCs of more batteries may be greater than the criterion SOC. Therefore, at a later point in time, the battery determining unit 130 may determine the target battery by considering the priorities of more batteries.

The battery determining unit 130 may be configured to provide information about the determined target battery.

Specifically, the information about the target battery may be provided to the user who requests battery replacement. For example, when a user requests battery replacement to the battery management apparatus 100 using a user terminal, the battery determining unit 130 may provide the information about the target battery to the user terminal. As another example, when the user requests battery replacement to the battery management apparatus 100 using the battery swapping station, the battery determining unit 130 may provide the information about the target battery to the battery swapping station.

Since the battery management apparatus 100 according to an embodiment of the present disclosure sets the priority by complexly considering the index values of the plurality of batteries, uneven deterioration of the plurality of batteries can be prevented. In particular, since the battery management apparatus 100 sets the priority by considering the relative deterioration and the relative usage amount of each of the plurality of batteries, it is possible to equally control deterioration of all batteries to a certain level. Therefore, according to the present disclosure, the problem of some batteries being used relatively a lot and deteriorating due to use, and some batteries being used relatively little and reducing utilization efficiency due to deterioration while waiting for use can be solved.

In addition, the battery management apparatus 100 has an advantage of improving the user experience because it recommends an optimal battery to the user among the plurality of batteries by complexly considering the battery information and the priority.

The battery management apparatus 100 may further include a storage unit 140. The storage unit 140 may store data necessary for operation and function of each component of the battery management apparatus 100, data generated in the process of performing the operation or function, or the like. The storage unit 140 is not particularly limited in its type as long as it is a known information storage means that can record, erase, update and read data. As an example, the information storage means may include RAM, flash memory, ROM, EEPROM, registers, and the like. In addition, the storage unit 140 may store program codes in which processes executable by each component of the battery management apparatus 100 are defined.

For example, the storage unit 140 may store the battery information about the plurality of batteries. Additionally, the storage unit 140 may store the performance index value and the priority of the battery determined by the priority setting unit 120.

Preferably, among the plurality of batteries provided in the battery swapping station, a battery that is already reserved (scheduled) as a replacement target may be excluded from the target battery determination.

For example, the battery information acquired by the communication unit 110 may include reservation information of the battery. Specifically, the reservation information may be included in the usage information of the battery. The priority setting unit 120 may check the reservation information of the plurality of batteries and set the priority for the remaining batteries except for the already reserved batteries.

The communication unit 110 may be configured to receive the battery replacement request and the information of the criterion location from the user terminal.

FIG. 4 is a diagram schematically showing the plurality of batteries and a criterion location according to an embodiment of the present disclosure.

The communication unit 110 may be configured to receive information about a location of the user terminal or a location designated by the user as information about the criterion location.

Specifically, the user may transmit a battery replacement request and information of the criterion location to the battery management apparatus 100 using a user terminal. Additionally, the communication unit 110 may receive the battery replacement request and the information of the criterion location transmitted from the user terminal.

For example, the user may basically set the location of the user terminal as the criterion location. Here, since the terminal of the user will be located at the user, the location of the user terminal may be strongly estimated as the location of the user. Accordingly, the user may transmit a battery replacement request and location information of the user terminal to the battery management apparatus 100 in order to request battery replacement at the current location of the user.

As another example, the user may transmit information of a directly designated location as information of the criterion location. For example, if the user is moving to a destination or is scheduled to move, the user may request battery replacement by specifying the destination as the criterion location.

For example, in the embodiment of FIG. 4, the point marked with "▪" represents the criterion location, and the circle marked with a solid line represents the threshold distance TH from the criterion location.

The battery determining unit 130 may be configured to select at least one candidate battery among the plurality of batteries based on the distance between the criterion location and the plurality of batteries.

Specifically, the battery determining unit 130 may select a candidate battery located within a preset threshold distance TH from the criterion location among the plurality of batteries, considering the straight line distance or path distance between the criterion location and the plurality of batteries. For example, the threshold distance TH may be preset by a program or user settings and may be changed by the user.

For example, in the embodiment of FIG. 4, among the first to ninth batteries B1 to B9, the batteries located within the threshold distance TH from the criterion location are the fourth to ninth batteries B4 to B9. Therefore, the battery determining unit 130 may select the fourth to ninth batteries B4 to B9 among the first to ninth batteries B1 to B9 as candidate batteries.

The battery determining unit 130 may be configured to determine the target battery based on the SOC and the priority of the selected candidate battery.

Specifically, the candidate battery is a battery determined according to the location from the criterion location. That is, the battery determining unit 130 may determine the target battery by comprehensively considering the location, the SOC, and the priority of the candidate battery.

For example, in the embodiment of FIG. 4, the battery determining unit 130 may determine any one of the fourth to ninth batteries B4 to B9 as the target battery, considering the SOC and the priority of the fourth to ninth batteries B4 to B9. Considering FIG. 3, the batteries having SOC greater than or equal to the criterion SOC are the fourth battery B4 and the seventh battery B7. Also, considering FIG. 2, since the priority of the fourth battery B4 is higher than the priority of the seventh battery B7, the battery determining unit 130 may determine the fourth battery B4 as the target battery.

The battery management apparatus 100 according to an embodiment of the present disclosure may select a replaceable candidate battery based on the criterion location (a location of the user terminal or a location designated by the user) and determine the target battery based on the SOC and the priority of the candidate battery. In other words, the battery management apparatus 100 has an advantage of providing the user with information about an optimal battery that comprehensively considers the location, the SOC, and the priority of the battery.

In one embodiment, the battery determining unit 130 may be configured to provide information about a battery swapping station including the determined target battery.

Specifically, the battery information received by the communication unit 110 may include identification information that can specify the battery and the battery swapping station. That is, the battery information may include the identification information, the state information, and the usage information. Therefore, when providing information about the determined target battery, the battery determining unit 130 may also provide information about the battery swapping station including the target battery.

The communication unit 110 may be configured to receive a battery replacement request from a battery swapping station.

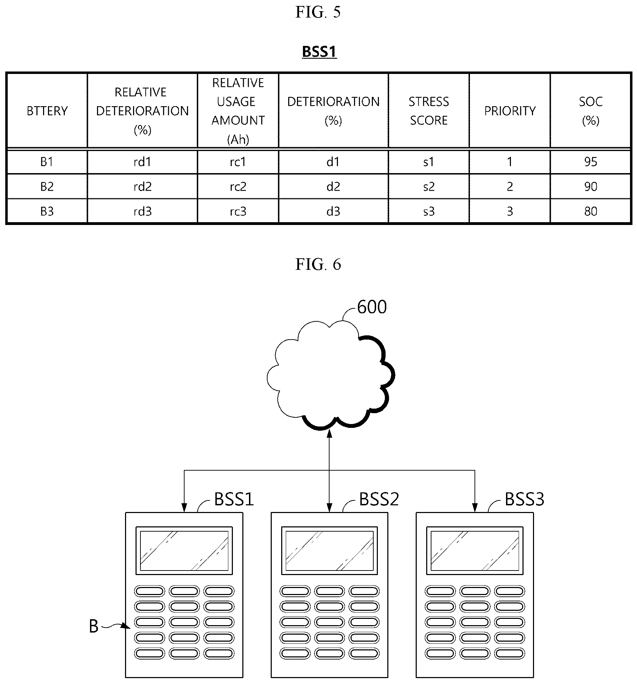

FIG. 5 is a diagram schematically showing a battery swapping station according to an embodiment of the present disclosure.

Specifically, the user may request battery replacement directly at the battery swapping station without using the user terminal. For example, the user may request battery replacement by manipulating the input unit included in the battery swapping station. In this case, the communication unit 110 may receive a battery replacement request and identification information about the battery swapping station.

The battery determining unit 130 may be configured to select at least one candidate battery provided in the battery swapping station among the plurality of batteries.

Specifically, because the user has requested battery replacement at the battery swapping station, the battery determining unit 130 may select the battery provided at the battery swapping station as a candidate battery.

The battery determining unit 130 may be configured to determine the target battery based on the SOC and the priority of the selected candidate battery.

Specifically, the battery determining unit 130 may determine the target battery by comprehensively considering the SOC and the priority of the candidate battery. Additionally, the battery determining unit 130 may transmit information about the target battery to the corresponding battery swapping station, so that the user may check the information about the target battery.

For example, in the embodiment of FIG. 5, assume that the user has requested battery replacement at the first battery swapping station BSS1, the first to third batteries B1 to B3 are provided at the first battery swapping station BSS1, and the criterion SOC is set to 90%. Among the candidate batteries, the batteries having SOC higher than or equal to the criterion SOC are the first battery B1 and the second battery B2. Since the priority of the first battery B1 is higher than the priority of the second battery B2, the battery determining unit 130 may determine the first battery B1 as the target battery. Additionally, the battery determining unit 130 may transmit information about the target battery to the first battery swapping station BSS1. The first battery swapping station BSS1 may receive the information about the target battery and output the information about the target battery through a display unit provided therein.

That is, when a battery replacement request is received from the battery swapping station, the battery management apparatus 100 according to an embodiment of the present disclosure may determine a target battery among candidate batteries provided at the corresponding battery swapping station, so that the user may quickly obtain the target battery.

In one embodiment, even though the communication unit 110 receives a battery replacement request from the battery swapping station, there may be no batteries provided at the battery swapping station, or all of the batteries provided may be reserved. In this case, the battery determining unit 130 may set the location of the battery swapping station as the criterion location and select a candidate battery located within a threshold distance TH from the set criterion location. Additionally, the battery determining unit 130 may determine the target battery based on the SOC and the priority of the candidate battery.

In another embodiment, even though the communication unit 110 receives a battery replacement request from the battery swapping station, the SOCs of all candidate batteries provided at the battery swapping station may be less than the criterion SOC. The battery determining unit 130 may determine a spare battery based on the SOC and the priority of the candidate battery. Here, the spare battery refers to a battery that does not meet the SOC standard, but can be determined as a target battery if charging is performed further to meet the SOC standard. In addition, the battery determining unit 130 may calculate the expected time required for the spare battery to meet the SOC standard by considering the charging specifications of the battery swapping station and the current SOC of the spare battery. The battery determining unit 130 may transmit information about the spare battery and the expected time to the battery swapping station. The information about the spare battery and the expected time may be output through the display unit of the battery swapping station.

Below, an embodiment in which the priority setting unit 120 calculates the relative deterioration of the plurality of batteries will be described.

The priority setting unit 120 may be configured to determine deterioration of each of the plurality of batteries based on the battery information.

Specifically, the deterioration of the battery refers to the SOH of the battery. For example, when the deterioration of the battery is included in the battery information, the priority setting unit 120 may determine the deterioration of the battery from the battery information. As another example, when the deterioration of the battery is not included in the battery information, the priority setting unit 120 may estimate the deterioration of the battery from the information that can be obtained from the battery information. Here, various conventional methods can be applied to estimate the deterioration of the battery.

The priority setting unit 120 may be configured to calculate relative deterioration for each of the plurality of batteries by comparing the calculated deterioration with a criterion deterioration preset for each of the plurality of batteries.

Here, the criterion deterioration is a deterioration preset to correspond to the usage history of the battery. For example, the corresponding relationship between the number of days of battery use and the deterioration may be mapped and stored in advance. For example, the criterion deterioration may mean a desirable deterioration set according to the number of days of battery use for quality assurance of the battery. In other words, the criterion deterioration is about a deterioration of each predefined period and means a deterioration expected for the number of days of battery use using a target deterioration within a specific period.

The priority setting unit 120 may check the number of days of use of the battery based on the usage information among the battery information and determine the criterion deterioration corresponding to the confirmed number of days of use. Additionally, the priority setting unit 120 may calculate relative deterioration for the battery based on the criterion deterioration and the deterioration of the battery.

For example, the priority setting unit 120 may calculate the relative deterioration for the battery by calculating the difference between the criterion deterioration and the deterioration of the battery. The priority setting unit 120 may calculate relative deterioration by calculating the formula "criterion deterioration - battery deterioration".

As another example, the priority setting unit 120 may calculate the relative deterioration of the battery by calculating the ratio of the deterioration of the battery to the criterion deterioration. The priority setting unit 120 may calculate relative deterioration by calculating the formula "battery deterioration ÷ criterion deterioration × 100".

Since the relative deterioration is an index based on the usage history and the deterioration of the battery, the degree of relative deterioration compared to the criterion deterioration can be compared by comparing the relative deteriorations even among a plurality of batteries with different deteriorations.

For example, assume that there are a battery A and a battery B. Although the deterioration of the battery A is higher than the deterioration of the battery B (i.e., the battery A is more deteriorated than the battery B), the relative deterioration of the battery A may be lower than the relative deterioration of the battery B. Also, lower relative deterioration means that the battery deteriorates faster. In other words, considering the criterion deterioration corresponding to the usage history, the battery B is more likely to deviate from the quality assurance standard than the battery A, so the priority of the battery A may be set higher than the battery B.

In order to guarantee the quality of a plurality of batteries, the battery management apparatus 100 may compare the relative deteriorations considering usage history rather than directly comparing deteriorations of the plurality of batteries.

Below, an embodiment in which the priority setting unit 120 calculates the relative usage amount of the plurality of batteries will be described.

The priority setting unit 120 may be configured to calculate the usage amount of each of the plurality of batteries based on the battery information.

Specifically, the usage amount refers to the amount the battery has been used until now. The priority setting unit 120 may calculate the usage amount of the battery by calculating the total discharge amount of the battery based on the usage information of the battery.

The priority setting unit 120 may be configured to calculate a relative usage amount of each of the plurality of batteries by comparing the criterion usage amount preset for each of the plurality of batteries with the calculated usage amount.

Here, the criterion usage amount is a usage amount preset to correspond to the usage history of the battery. For example, the corresponding relationship between the number of days of battery use and the usage amount may be mapped and stored in advance. For example, the criterion usage amount may mean a desirable usage amount set according to the number of days of battery use to ensure battery quality. In other words, the criterion usage amount relates to the usage amount for each predefined period and means the usage amount expected for each number of days of use using the target usage amount within a specific period.

The priority setting unit 120 may check the number of days of use of the battery based on the usage information among the battery information and determine a criterion usage amount corresponding to the checked number of days of use. Additionally, the priority setting unit 120 may calculate the relative usage amount for the battery based on the criterion usage amount and the usage amount of the battery.

For example, the priority setting unit 120 may calculate the relative usage amount for the battery by calculating the ratio of the usage amount of the battery to the criterion usage amount. The priority setting unit 120 may calculate the relative usage amount by calculating the formula "battery usage amount ÷ criterion usage amount × 100".

Since the relative usage amount is an index based on the usage history of the batter and the usage amount, the degree of relative deterioration compared to the criterion usage amount may be compared by comparing the relative usage amount even among a plurality of batteries with different usage amounts.

In order to guarantee the quality of the plurality of batteries, the battery management apparatus 100 may compare the relative usage amounts considering the usage history rather than directly comparing the usage amounts between the plurality of batteries.

Below, an embodiment in which the priority setting unit 120 calculates the stress score of the plurality of batteries will be described.

Here, the stress score quantifies and scores the use of major patterns that apply stress to the battery, the number of uses, and the rate of use. For example, batteries are subject to physical and chemical stress depending on usage patterns, which may accelerate deterioration. In other words, irreversible damage may occur within the battery. Examples of major patterns that cause stress to the battery include full charging, waiting after full charging, full discharging, and using high output at low temperatures.

The priority setting unit 120 may be configured to check the usage pattern of each of the plurality of batteries based on the battery information. Additionally, the priority setting unit 120 may be configured to calculate a stress score for each of the plurality of batteries by comparing the usage pattern of each of the plurality of batteries with a preset main pattern.

For example, the priority setting unit 120 may check the use of major patterns, the number of times of use of major patterns, and the rate of use of major patterns based on the usage information among the battery information. If a battery has a long history of major patterns such as full charge and full discharge, the stress score may be calculated higher than other batteries. Also, the higher the stress score, the lower the priority can be set. In other words, the priority setting unit 120 may determine the target battery so that the plurality of batteries can be degraded evenly by setting the priority by considering the use of major patterns that can apply physical and chemical stress to the battery.

Below, the description will be made assuming that there are multiple preset performance indexes.

The priority setting unit 120 may be configured to determine the plurality of index values for each of the plurality of batteries.

In one embodiment, the priority setting unit 120 may be configured to set the priority for the plurality of batteries by comparing index values from a performance index with a preset high importance.

For example, in the embodiment of FIG. 2, it is assumed that the importance of the performance index is high in the order of the relative deterioration, the relative usage amount, the deterioration, and the stress score. The priority setting unit 120 may set the priority of the first to ninth batteries B1 to B9 by first comparing the relative deteriorations. Here, the priorities of batteries with the same relative deterioration may be the same. Next, for batteries with the same priority according to the relative deterioration, the priority setting unit 120 may set the priority by comparing the relative usage amounts. In this way, the priority setting unit 120 may set a plurality of priorities by sequentially considering the relative deterioration, the relative usage amount, the deterioration, and the stress score.

In another embodiment, the priority setting unit 120 may be configured to calculate a state score for each battery based on the plurality of determined index values. Additionally, the priority setting unit 120 may be configured to set the priority for the plurality of batteries according to the calculated state score.

Specifically, the priority setting unit 120 may be configured to calculate a state score by weighting and adding a preset weight for each of the plurality of performance index to the corresponding index value.

For example, in the embodiment of FIG. 2, the weight may be set in advance for each of the relative deterioration, the relative usage amount, the deterioration, and the stress score. Here, the weight for each performance index may be the same or different. Additionally, the weight of each performance index may be adjusted depending on the selection of the user. The priority setting unit 120 may add a weight to each of the relative deterioration, the relative usage amount, the deterioration, and the stress score, and calculate the state score for each battery by adding up the weighted values. Here, the state score is a value that can be directly compared for the plurality of batteries. Therefore, the priority setting unit 120 may set the priority of the plurality of batteries by directly comparing the state scores of the plurality of batteries.

FIG. 6 is a diagram schematically showing a server 600 according to another embodiment of the present disclosure.

Referring to FIG. 6, the server 600 may include the battery management apparatus 100. Additionally, the server 600 may be connected to communicate with at least one battery swapping station. For example, in the embodiment of FIG. 6, the server 600 may be connected to communicate with the first to third battery swapping stations BSS1, BSS2, and BSS3.

Each battery swapping station includes an input unit, a display unit, and a battery unit, and the battery unit may be equipped with a battery. Preferably, the battery included in the battery unit may be charged up to a preset charging end voltage. Also, a battery having SOC higher than the criterion SOC may become a candidate battery that can be determined as a target battery. The battery swapping station may periodically transmit the battery information about the battery provided in the battery unit to the server 600.

The server 600 may periodically receive the battery information about the plurality of batteries from the plurality of battery swapping stations. Also, when a battery replacement request is input by the user, the server 600 may determine an optimal battery among the plurality of batteries as the target battery and provide information about the target battery to the user.

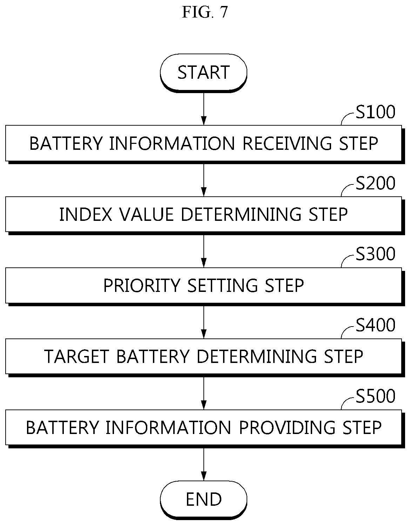

FIG. 7 is a diagram schematically showing a battery management method according to still another embodiment of the present disclosure.

Referring to FIG. 7, the battery management method may include a battery information receiving step (S100), an index value determining step (S200), a priority setting step (S300), a target battery determining step (S400) and a battery information providing step (S500).

Preferably, each step of the battery management method may be performed by the battery management apparatus 100. Hereinafter, for convenience of explanation, contents overlapping with the previously described contents will be omitted or briefly described.

The battery information receiving step (S100) is a step of receiving battery information about a plurality of batteries, and may be performed by the communication unit 110.

For example, the communication unit 110 may be connected to communicate with at least one battery swapping station. Additionally, the communication unit 110 may receive battery information about the battery provided in the battery swapping station from the battery swapping station.

The index value determining step (S200) is a step of determining an index value for a performance index preset for the plurality of batteries, based on the battery information, and may be performed by the priority setting unit 120.

For example, the priority setting unit 120 may determine index values for deterioration, relative deterioration, relative usage amount, and stress score of each of the plurality of batteries using the battery information.

The priority setting step (S300) is a step of setting a priority for the plurality of batteries based on the determined index value, and may be performed by the priority setting unit 120.

For example, since a battery with a high priority is likely to be selected as a target battery that is a replacement target, the priority setting unit 120 may determine the priorities for the plurality of batteries not to overlap based on the determined index value.

The target battery determining step (S400) is a step of determining a target battery among the plurality of batteries based on the battery information and the priority, and may be performed by the battery determining unit 130.

For example, the battery determining unit 130 may be configured to determine a battery having the highest priority and an SOC greater than or equal to a preset criterion SOC, among the plurality of batteries, as the target battery.

The battery information providing step (S500) is a step of providing information about the determined target battery, and may be performed by the battery determining unit 130.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

100: battery management apparatus
110: communication unit
120: priority setting unit
130: battery determining unit
140: storage unit
600: server

## Claims

1. A battery management apparatus, comprising:
a communication unit configured to receive battery information for a plurality of batteries;
a priority setting unit configured to determine an index value of a performance index preset for the plurality of batteries based on the battery information and set a priority for the plurality of batteries based on the determined index value; and
a battery determining unit configured to determine a target battery among the plurality of batteries based on the battery information and the priority and provide information about the determined target battery.

2. The battery management apparatus according to claim 1,
wherein the battery determining unit is configured to check SOC of each of the plurality of batteries based on the battery information and determine a battery having the highest priority and having SOC greater than or equal to a preset criterion SOC among the plurality of batteries as the target battery.

3. The battery management apparatus according to claim 2,
wherein the communication unit is configured to receive a battery replacement request and information of a criterion location from a user terminal, and
wherein the battery determining unit is configured to select at least one candidate battery among the plurality of batteries based on a distance between the criterion location and the plurality of batteries and determine the target battery based on the SOC and the priority of the selected candidate battery.

4. The battery management apparatus according to claim 3,
wherein the communication unit is configured to receive information of a location of the user terminal or a location specified by a user as the information of the criterion location.

5. The battery management apparatus according to claim 2,
wherein the communication unit is configured to receive a battery replacement request from a battery swapping station, and
wherein the battery determining unit is configured to select at least one candidate battery provided in the battery swapping station among the plurality of batteries and determine the target battery based on the SOC and the priority of the selected candidate battery.

6. The battery management apparatus according to claim 1,
wherein the performance index is configured to include at least one of deterioration, relative deterioration, relative usage amount, and stress score of each of the plurality of batteries.

7. The battery management apparatus according to claim 6,
wherein the priority setting unit is configured to determine the deterioration of each of the plurality of batteries based on the battery information and calculate the relative deterioration of each of the plurality of batteries by comparing the calculated deterioration with a criterion deterioration preset for each of the plurality of batteries.

8. The battery management apparatus according to claim 6,
wherein the priority setting unit is configured to calculate a usage amount of each of the plurality of batteries based on the battery information and calculate the relative usage amount of each of the plurality of batteries by comparing the calculated usage amount with a criterion usage amount preset for each of the plurality of batteries.

9. The battery management apparatus according to claim 6,
wherein the priority setting unit is configured to check a usage pattern of each of the plurality of batteries based on the battery information and calculate the stress score of each of the plurality of batteries by comparing the usage pattern of each of the plurality of batteries with a preset main pattern.

10. The battery management apparatus according to claim 1,
wherein when the preset performance index is plural, the priority setting unit is configured to determine a plurality of index values for each of the plurality of batteries and set a priority for the plurality of batteries by comparing the index values from a performance index with a preset high importance.

11. The battery management apparatus according to claim 1,
wherein when the preset performance index is plural, the priority setting unit is configured to determine a plurality of index values for each of the plurality of batteries, calculate a state score for each battery based on the plurality of determined index values, and set a priority for the plurality of batteries according to the calculated state score.

12. The battery management apparatus according to claim 11,
wherein the priority setting unit is configured to calculate the state score by weighting and adding a weight preset for each of the plurality of performance indexes to the corresponding index value.

13. A server, comprising the battery management apparatus according to any one of claims 1 to 12.

14. A battery management method, comprising:
a battery information receiving step of receiving battery information for a plurality of batteries;
an index value determining step of determining an index value of a performance index preset for the plurality of batteries based on the battery information;
a priority setting step of setting a priority for the plurality of batteries based on the determined index value;
a target battery determining step of determining a target battery among the plurality of batteries based on the battery information and the priority; and
a battery information providing step of providing information about the determined target battery.
